# EUROPEAN PATENT APPLICATION

(11) **EP 2 251 700 A1**
(43) Date of publication of application: **17.11.2010**
(21) Application number: 09160002.3
(22) Date of filing: 12.05.2009
(51) Int. Cl.: G01R 11/24

(54) **Magnetically immune consumption meter**

(71) Applicant: KAMSTRUP A/S, 8660 Skanderborg (DK)
(72) Inventor: Hansen, Gorm Bass, 8722, Hedensted (DK)
(74) Representative: Plougmann & Vingtoft A/S

(57) **Abstract**

A consumption meter comprising a legal circuit for measuring a physical parameter of a physical entity and for generating a consumed quantity accordingly. The meter comprises a power supply for powering at least the legal circuit. The power supply is arranged to convert a first voltage from an electric power line into a lower supply voltage, wherein the conversion from the first voltage to the lower supply voltage involves conversion from electric energy into mechanical energy and conversion from the mechanical energy into electric energy. Such meter, e.g. an electricity meter, is suitable to provide a magnetically tampering immune consumption meter. Preferably, the power supply comprises a piezoelectric transformer to provide this conversion. Such transformer is magnetically immune, rather inexpensive, small, and can provide a high conversion efficiency, thus making such type of transformer suited to built into the casing of a compact consumption meter, e.g. an electricity meter.

## Description

### FIELD OF THE INVENTION

The invention relates to the field of consumption meter, such as a consumption meter for measuring an amount of electricity, heat, cooling, gas or water. In particular the invention provides a consumption meter which is generally immune to magnetic fields. More specifically, the consumption meter has a power supply which allows the meter to function also during influence of strong magnetic fields.

### BACKGROUND OF THE INVENTION

Magnetic tampering of consumption meter, especially electrical meters, has always been an issue, since the consumer by this could affect the billing amount. On traditional Ferraris type electrical meters, based on a disc rotating by means of an electromagnetic field, a magnet placed adjacent to the meter could slow down or completely prevent the rotation, lowering the counting thus the amount to be billed.

Electronic meters on its part require a power supply for its measuring circuit. Per tradition it has been conducted via a transformer based on electromagnetic principles. Such transformer can also be influenced by adjacent magnets with the same result, because the power capacity of the power supply can be reduced significantly by a strong magnetic field due to the destroyed electromagnetic function of the transformer. Hereby, the supply power for the vital electronic measurement and calculation circuits can be too low for the circuits to function, and thus the meter will stop functioning.

WO 2008/055507 by Kamstrup A/S describes an electricity meter with a switch mode power supply. A switching circuit generates a pulsating current through a primary winding of an electromagnetic transformer. Such power supply can be made rather resistant to magnetic tampering. This is due to a high switching frequency, the electromagnetic transformer can easily be dimensioned such that it is still able to deliver sufficient power for the vital meter circuits even during influence of a strong magnetic field. However, due to such dimensioning the transformer can be rather expensive and have large dimensions.

Another solution to the magnetic tampering problem is an electricity meter with a capacitive power supply. A capacitive voltage divider is provided by means of two capacitors, hereby providing a power supply which is insensible to magnetic tampering. However, due to the required capacitor value and size of at least one of such capacitors, such power supply will typically only be used to power the most vital circuits of the meter.

### SUMMARY OF THE INVENTION

In view of the above, it may be seen as an object of the present invention to provide a consumption meter, e.g. an electricity meter, with a power supply which is magnetically immune, has a small size, which has a power capacity sufficient to power all functions relating to the meter, and which is still suited for low cost mass production.

The invention provides a consumption meter arranged to measure a consumed quantity of a physical entity, the meter comprising
- a legal circuit arranged to perform a measurement of a physical parameter related to the physical entity and to generate a quantity value representing the consumed quantity accordingly, and
- a power supply for powering at least the legal circuit, wherein the power supply is arranged to convert a first voltage from an electric power line into a lower supply voltage, wherein the conversion from the first voltage to the lower supply voltage involves conversion from electric energy into mechanical energy and conversion from the mechanical energy into electric energy.

The term 'legal circuit' is used to denote the circuit element which are vital for the function of the meter, since in consumption meters certified for charging purposes, such circuits are bound by legal requirements. Thus, the power supply is arranged to at least provide electric power to drive the circuits responsible for the basic meter function.

Such consumption meter with a power supply based on electric-to-mechanical-to-electric transformation can be implemented without involvement of any magnetically sensitive elements. Thus, the meter can be made immune to magnetic tampering. Further, such transformation principle in the power supply can be implemented with components of compact dimensions and high efficiency, and thus it is still possible to build such components into the meter casing, e.g. inside the casing of an electricity meter, and still provide enough electric power to power all circuits related to the consumption meter, including a rather power consuming wireless Radio Frequency transmitter for remote reading purposes. Still further, such components of the power supply are rather inexpensive and thus suited for large scale, low cost production.

It is appreciated that the power supply can be integrated with the consumption meter, such as housed within the meter housing, which will typically be preferred in case of an electricity meter, or the power supply can be housed in a casing separate from the consumption meter, which may be preferred for other types of consumption meters such as heat meters or cooling meters.

In a preferred embodiment, the power supply comprises a piezoelectric transformer arranged to perform said conversion from electric energy into mechanical energy and conversion from the mechanical energy into electric energy. Such piezoelectric transformer is rather inexpensive since it can be produced in a highly automated manufacturing process, the piezoelectric material is non-magnetic and is thus magnetically tampering immune, it can convert electric energy at a high efficiency and can thus provide a high electric power in spite of rather compact dimensions.

A piezoelectric voltage conversion element is rather easy to manufacture in a uniform quality, and compared to magnetic transformers, problems related to delicate windings are eliminated. This means that a power supply based on a piezoelectric voltage conversion element is more reliable than a corresponding supply based on a traditional transformer element.

Thus, a piezoelectric transformer is advantageous for the purpose of providing an electric-to-mechanical-to-electric conversion from one voltage to another voltage in a power supply. With comparable power capacity, a piezoelectric transformer can be smaller than a conventional electromagnetic transformer. Furthermore, a piezoelectric transformer typically exhibits a lower Electromagnetic radiation level than conventional transformers. Further, due to a high electric-to-electric conversion efficiency, the piezoelectric transformer will only generate a small amount of heat, which again facilitates the fitting of such transformer within the consumption meter casing without the need for special heat dissipating measures. Still further, a piezoelectric transformer can be implemented by ceramic materials and is thus a non-flammable component.

US 6,707,235 B1 by Noliac A/S discloses an example of a piezoelectric transformer with galvanic separation between the primary and secondary electric sides. The function of a piezoelectric transformer is that an alternating voltage at the primary side is applied to a piezoelectric element which transfers the electric voltage to mechanical energy in the form of vibrations. This vibration propagates through an isolating layer to a second piezoelectric element which generates an alternating voltage in response to the vibrations.

The first and second piezoelectric elements are mechanically arranged such in relation to each other with an intermediate mechanical structure, that they vibrate at a certain a natural frequency, a resonance frequency. The piezoelectric transformer provides the most efficient coupling between the primary and secondary sides for input voltages having a frequency in the range around the resonance frequency. Thus, circuits exist that serve to transfer a given electric alternating voltage, e.g. 50 or 60 Hz directly from the public electric net, to an alternating voltage suited for the specific piezoelectric transformer configuration in question, so as to provide a high electric conversion efficiency in the transformer.

Piezoelectric transformers are available in versions suited to up or down transform a voltage at the primary side to a voltage at the secondary side with a conversion factor. In an embodiment of the present invention, the piezoelectric transformer is arranged to convert voltages with a suitable voltage conversion factor, such that the power supply converts the first voltage from the electric power line to the lower supply voltages at a voltage conversion factor within a range of 0.001 - 0.2.

Preferably, the piezoelectric transformer provides a galvanic separation between its primary electric side and its secondary electric side. Hereby, the power supply is suited for electricity meters, where such isolation is typically preferred or demanded.

Preferably, the piezoelectric transformer comprises a plurality of separate voltage outputs at its secondary electric side. Hereby, electric circuits in the meter requiring different supply voltage ranges can be powered from such separate voltage outputs that generate different output voltages. In one embodiment, such plurality of separate voltage outputs is galvanic separate from each other. Hereby, such transformer is suited for powering measurement circuits for separate phases of an electricity meter, where typically such galvanic separation is required. Thus, in one embodiment, the consumption meter is an electricity meter, and separate measurement circuits are arranged for performing measurements on respective electric phases of the power line, and wherein the separate measurement circuits are powered from respective ones of the separate voltage outputs. A first one of the separate voltage outputs may be arranged to generate the supply voltage to the legal circuit. A separate voltage output may be arranged to power a communication module arranged to transmit a data value representing the consumed quantity, such as a wireless Radio Frequency transmitter. Further, a separate voltage output may be arranged to power one or more auxiliary circuits, such as one or more of: a smoke detector, an alarming circuit such as a leakage alarming circuit, and a power switch etc.

Preferably, the meter comprises a switch mode driver circuit connected to a primary electric side of the piezoelectric transformer, such as a switch mode driver circuit operating at an operating frequency higher than 10 kHz, such as higher than 100 kHz. Especially, the operating frequency of the driver circuit may be selected based on a resonance frequency of the piezoelectric transformer, such as the operating frequency being selected to be within +/- 20% of the resonance frequency of the piezoelectric transformer, thus providing a high efficiency, as explained. In spite of the operating frequency of the driver circuit may be closely related to the resonance frequency of the piezoelectric transformer, the driver circuit may be designed to generate an output signal to the piezoelectric transformer which has a frequency substantially coinciding with a sub-harmonic of a resonance frequency of the piezoelectric transformer.

The switch mode driver circuit may be arranged to adjust the operating frequency in response to a feedback signal, e.g. a feedback signal from the secondary electric side of the piezoelectric transformer and/or a feedback signal from the primary electric side of the piezoelectric transformer. The switch mode driver circuit is preferably connected to the power line via a rectifier, such as via a rectifier and a filter.

The meter may comprise a regulation circuit connected to the switch mode driver circuit, such as a regulation circuit connected to the switch mode driver circuit in a feed back loop. Such regulation circuit may be connected via a feedback signal at the primary electric side of the piezoelectric transformer and a drive signal. A feed back loop may be provided between the secondary electric side and the primary electric side of the piezoelectric transformer. Especially, the regulation circuit may be arranged to receive a feedback signal from the secondary electric side of the piezoelectric transformer, e.g. based on a supply voltage output, and to generate an according signal to a driver circuit connected to the primary electric side of the piezoelectric transformer.

Preferably, the power supply is arranged for connection to an electric power line providing a first voltage within the range of 50 - 1000 V, such as within the range of 100 - 500 V. Hereby, the power supply is suited for use with typical public electric nets.

The consumption meter may be an electricity meter, a heat meter, a cooling meter, a water meter, or a gas meter.

It is appreciated that two or more of the mentioned embodiments can advantageously be combined.

### BRIEF DESCRIPTION OF THE DRAWINGS

Embodiments of the invention will be described, by way of example only, with reference to the drawings, in which
Fig. 1 illustrates a block diagram of one consumption meter embodiment with a piezoelectric transformer having a single voltage output, such as suitable for a heat meter or a cooling meter,
Fig. 2 illustrates a block diagram of 3-phase electricity meter embodiment with a piezoelectric transformer having a plurality of separate voltage outputs, and
Fig. 3 illustrates a block diagram of yet another consumption meter embodiment with a piezoelectric transformer with feedback from two of its three voltage outputs.

### DESCRIPTION OF EMBODIMENTS

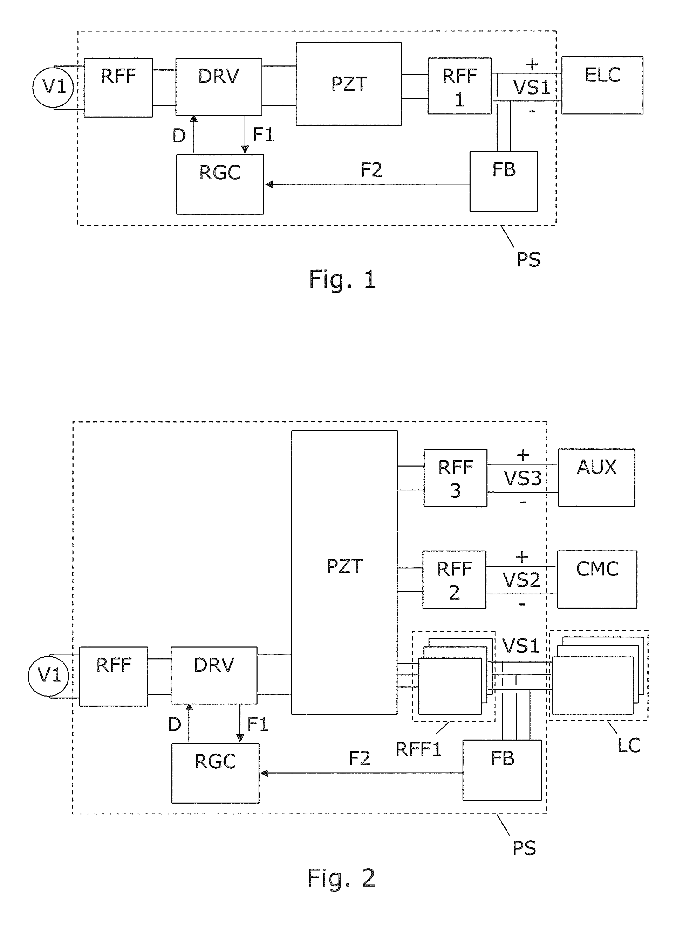

Fig. 1 shows a block diagram of selected components of a consumption meter, e.g. a heating meter or a cooling meter, illustrating details of its power supply PS which is supplied by electric power from an electric AC power line at voltage V1, e.g. the electric public net supply at V1=230 V. In this embodiment, the power supply PS has only one output voltage VS1 to power electronic circuits ELC involved in the vital meter functions, i.e. all legal circuits as well as other functions of the meter, i.e. circuits such as a Radio Frequency transmitter circuit arranged for remote reading of the consumption meter and possible auxiliary circuits. Such supply power configuration may be preferred for heating meters or cooling meters.

The power supply PS may be integrated with the consumption meter, e.g. built into the casing that houses the meter circuits, which may be preferred in case of an electricity meter. Alternatively, for heat meters and cooling meters, it may be preferred that the power supply PS has a separate casing and supplies the low voltage signal VS1 to the meter circuits ELC via an external wire.

At the AC power input of the power supply PS, a rectifier and filter circuit RFF serves to rectify and filter the AC power line voltage V1 and provide the rectified and filtered voltage to a driver circuit DRV. The driver circuit DRV is electrically connected to drive a primary electric side of a piezoelectric transformer PZT. Especially, such driver circuit DRV is suited to obtain a high conversion efficiency of the piezoelectric transformer PZT by driving it in the frequency range around its mechanical resonance frequency, this resonance frequency being determined by the mechanical configuration of the piezoelectric transformer, but which is also influenced by the load of the piezoelectric transformer. In fact the resonance frequency depends both on the load on the primary and secondary electric sides of the transformer. Such driver circuit DRV is typically in the form of a switch mode circuit operating at an operating frequency in the 50 kHz, 100 kHz or even higher, e.g. selected at or at least near the resonance frequency of the piezoelectric transformer PZT. However, the driver circuit DRV may generate an output signal, e.g. in the form of pulses, to drive the primary electric side of the piezoelectric transformer PZT which has a frequency at or near a sub-harmonic of the resonance frequency of the piezoelectric transformer PZT. By driving the primary electric side of the piezoelectric transformer PZT at or near a sub-harmonic of its resonance frequency, it is ensured that driving pulses are applied at time instants where they support the mechanical vibration of the piezoelectric transformer PZT.

The embodiment of Fig. 1 has a piezoelectric transformer PZT with a single voltage-to-voltage conversion element and thus a single voltage output, resulting in a single voltage output VS1 from the power supply PS. A rectifier and a filter circuit RFF1 are provided to rectify and filter the electric output from the transformer PZT and provide a DC voltage VS1 suited to drive the electronic circuits ELC of the meter, e.g. a DC voltage such as 3.6 V, 5 V or 10 V, or the like.

A feedback is provided between the secondary and primary electric sides of the piezoelectric transformer PZT in order to control the driver circuit DRV to provide a stable voltage VS1. This feedback is illustrated as a feedback interface FB connected to sense the output voltage VS1. The feedback interface FB provides a feedback signal F2 accordingly to a regulation circuit RGC which is connected to the driver circuit DRV in a feedback loop by providing a drive signal D to the driver circuit DRV and by receiving in response a feedback signal F1 from the driver circuit DRV.

Especially, the driver circuit DRV may, indirectly via the regulation circuit RGC and drive signal D, adjust its operating frequency in response to the feedback F2 from the secondary electric side of the piezoelectric transformer PZT, and further the driver circuit DRV may be arranged to adjust frequency of its output signal to drive the piezoelectric transformer in response to the feedback F2 from the secondary electric side. The feedback signal F2 may be used by the driver circuit DRV to synchronize the frequency of its output signal to drive the piezoelectric transformer PZT in response to a detected resonance frequency of the piezoelectric transformer PZT, since the resonance frequency of the piezoelectric transformer PZT will typically vary according to the load of its secondary electric side.

Fig. 2 illustrates a configuration typical for a 3-phase electricity meter. Galvanic separate secondary electric outputs from the piezoelectric transformer PZT are used to provide separate voltage outputs V1, V2, V3 from the power supply PS. Especially, it is seen that the legal circuits LC involved in the vital meter functions are separated into three circuits, one for each electric phase, and thus the voltage output VS1 is separated into three galvanic separate outputs, one for the circuit for each electric phase. At each of the secondary electric outputs of the piezoelectric transformer PZT, respective rectifier and filter circuits RFF1, RFF2, RFF3 are connected to rectify and filter the electric outputs from the transformer PZT and provide DC voltages VS1, VS2, VS3. These DC voltages VS1, VS2, VS3 are suited to, respectively, drive 1) the legal circuits LC involved in the vital meter functions such as measurement circuit, calculator circuit, display etc., 2) communication circuits CMC, e.g. a wireless Radio Frequency communication module, and 3) auxiliary circuits AUX e.g. a smoke detector etc. The DC voltages VS1, VS2, VS3 may be different or they may represent the same voltage levels.

A feedback is provided between the secondary and primary electric sides of the piezoelectric transformer PZT in order to control the driver circuit DRV to provide stable voltages VS1, VS2, VS3. In this embodiment, this feedback is illustrated as a feedback interface FB connected to sense only one of the three output voltages, namely VS1 used to drive the legal circuits LC. Especially, it is seen that the feedback interface FB is connected to sense all three separate voltage outputs VS1, however it may be preferred only to provide feedback from a selected one of the three outputs of VS1.

As also illustrated and described in relation to Fig. 1, the feedback interface FB provides a feedback signal F2 accordingly to a regulation circuit RGC which is connected to the driver circuit DRV in a feedback loop by providing a drive signal D to the driver circuit DRV and by receiving in response a feedback signal F1 from the driver circuit DRV. Preferably, the feedback F2 between the secondary and primary electric sides of the piezoelectric transformer PZT is based on the secondary electric output powering the most power demanding ones of the circuits LC, CMC, AUX. In some cases this may be the communication circuit CMC which in RF transmission mode can be rather power consuming. However, since the communication circuits CMC is only active in short intervals, in the embodiment of Fig. 2 is has been chosen to select VS1, i.e. the legal circuit LC supply voltage, to provide the feedback signal F2, since hereby a feedback signal F2 will always be available because the legal circuits LC are always active.

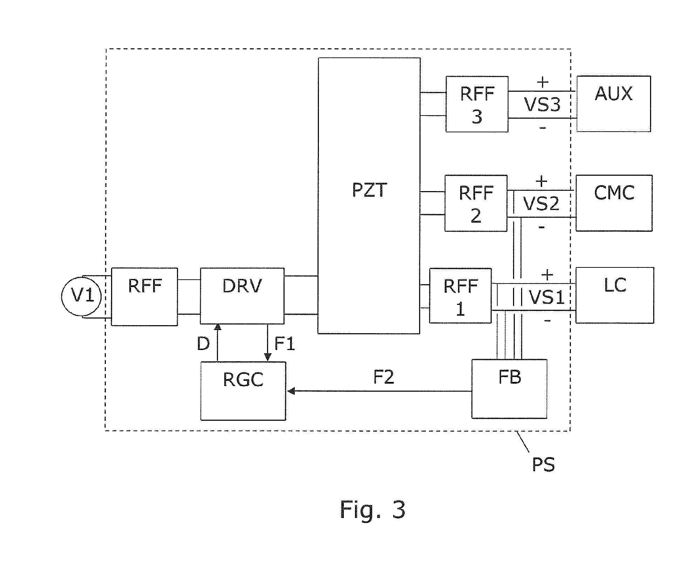

Fig. 3 illustrates a slightly different version of the embodiment of Fig. 2, e.g. as can be used for a one-phase electricity meter. As seen, the difference between the embodiments of Fig. 2 and 3 is the feedback from the secondary electric side of the piezoelectric transformer PZT. In Fig. 3, the feedback interface FB is arranged to generate a feedback signal F2 in response to an input in the form of both of the first and second supply voltages VS1, VS2, i.e. the supply voltages to the legal circuits LC and the communication circuits CMC, which may be different DC voltage levels. Hereby, it is possible to provide a feedback signal F2 from the secondary electric side of the piezoelectric transformer PZT which takes into account both the rather constant load from the legal circuits LC as well as the short term heavy load from the communication circuits CMC.

Typically, the output voltages required to drive the circuits LC, CMC, AUX are below 20 V, e.g. below 10 V. Thus, the power supply PS may thus provide voltage-to-voltage conversion factors such as approximately below 0.05 in case of a 230 V AC power input V1. To obtain this voltage conversion for the power supply PS, the piezoelectric transformer PZT is selected to have a suitable voltage step down factor.

As already mentioned, a piezoelectric transformer PZT suited for such power supply PS in a consumption meter is commercially available. A suitable driver circuit DRV fitting an actual piezoelectric transformer PZT and an actual application, e.g. in the form of an ASIC, should be designed especially according to the specific conditions, in order to provide a high conversion efficiency. However, by careful design of the driver circuit DRV and with the use of feedback F1, F2 from both of the primary and secondary electric sides of the piezoelectric transformer PZT, it is possible to obtain a power supply PS providing a high voltage-to-voltage conversion efficiency.

In a preferred embodiment, the power supply PS is built into the casing of an electricity meter, e.g. a three-phase electricity meter, where galvanic separate secondary electric side outputs are provided from the piezoelectric transformer to drive separate measurement circuits for each of the three electric phases.

To sum up, the invention provides a consumption meter comprising a legal circuit for measuring a physical parameter of a physical entity and for generating a consumed quantity accordingly. The meter comprises a power supply for powering at least the legal circuit. The power supply is arranged to convert a first voltage from an electric power line into a lower supply voltage, wherein the conversion from the first voltage to the lower supply voltage involves conversion from electric energy into mechanical energy and conversion from the mechanical energy into electric energy. Such meter, e.g. an electricity meter, is suitable to provide a magnetically tampering immune consumption meter. Preferably, the power supply comprises a piezoelectric transformer to provide this conversion. Such transformer is magnetically immune, rather inexpensive, small, and can provide a high conversion efficiency, thus making such type of transformer suited to built into the casing of a compact consumption meter, e.g. an electricity meter.

Although the present invention has been described in connection with preferred embodiments, it is not intended to be limited to the specific form set forth herein. Rather, the scope of the present invention is limited only by the accompanying claims.

In this section, certain specific details of the disclosed embodiments are set forth for purposes of explanation rather than limitation, so as to provide a clear and thorough understanding of the present invention. However, it should be understood readily by those skilled in this art, that the present invention may be practised in other embodiments which do not conform exactly to the details set forth herein, without departing significantly from the spirit and scope of this disclosure. Further, in this context, and for the purposes of brevity and clarity, detailed descriptions of well-known apparatus, circuits and methodology have been omitted so as to avoid unnecessary detail and possible confusion.

In the claims, the term "comprising" does not exclude the presence of other elements or steps. Additionally, although individual features may be included in different claims, these may possibly be advantageously combined, and the inclusion in different claims does not imply that a combination of features is not feasible and/or advantageous. In addition, singular references do not exclude a plurality. Thus, references to "a", "an", "first", "second" etc. do not preclude a plurality. Reference signs are included in the claims however the inclusion of the reference signs is only for clarity reasons and should not be construed as limiting the scope of the claims.

## Claims

1. A consumption meter arranged to measure a consumed quantity of a physical entity, the meter comprising
- a legal circuit (LC) involved in performing a measurement of a physical parameter related to the physical entity and to generate a quantity value representing the consumed quantity accordingly, and
- a power supply (PS) for powering at least the legal circuit (LC), wherein the power supply (PS) is arranged to convert a first voltage (V1) from an electric power line into a lower supply voltage (VS1), wherein the conversion from the first voltage (V1) to the lower supply voltage (VS1) involves conversion from electric energy into mechanical energy and conversion from the mechanical energy into electric energy.

2. Consumption meter according to claim 1, wherein the power supply (PS) comprises a piezoelectric transformer (PZT) arranged to perform said conversion from electric energy into mechanical energy and conversion from the mechanical energy into electric energy.

3. Consumption meter according to claim 2, wherein the piezoelectric transformer (PZT) exhibits a voltage-to-voltage conversion so as to provide a conversion factor for the power supply (PS) from the first voltage (V1) from the electric power line to the lower supply voltage (VS1) within a range of 0.001 - 0.2.

4. Consumption meter according to claim 2 or 3, wherein the piezoelectric transformer (PZT) provides a galvanic separation between its primary electric side and its secondary electric side.

5. Consumption meter according to any of the preceding claims, such as a heat meter or a cooling meter, wherein the piezoelectric transformer (PZT) has a single voltage output (VS1) for powering all power demanding circuits (ELC) of the consumption meter.

6. Consumption meter according to any of claims 2-4, wherein the piezoelectric transformer (PZT) comprises a plurality of separate voltage outputs (VS1, VS2, VS3) at its secondary electric side.

7. Consumption meter according to claim 6, wherein at least two of the plurality of separate voltage outputs (VS1, VS2, VS3) are galvanic separate from each other.

8. Consumption meter according to claim 6 or 7, wherein a first one of the separate voltage outputs (VS1) is arranged to generate the supply voltage to the legal circuit (LC).

9. Consumption meter according to any of claims 6-8, wherein a separate voltage output (VS2) is arranged to power a communication module (CMC) arranged to transmit a data value representing the consumed quantity, such as a wireless Radio Frequency transmitter.

10. Consumption meter according to any of claims 6-9, wherein a separate voltage output (VS3) is arranged to power one or more auxiliary circuits, such as one or more of: a smoke detector, an alarming circuit, and a power switch.

11. Consumption meter according to any of claims 2-10, comprising a switch mode driver circuit (DRV) connected to a primary electric side of the piezoelectric transformer (PZT), wherein the switch mode driver circuit (DRV) is arranged to operate at an operating frequency, such as an operating frequency higher than 10 kHz, such as higher than 100 kHz, such as the driver circuit (DRV) generating an output signal to the piezoelectric transformer (PZT) with a frequency substantially coinciding with a sub-harmonic of a resonance frequency of the piezoelectric transformer (PZT).

12. Consumption meter according to claim 11, wherein the operating frequency of the driver circuit (DRV) is selected based on a resonance frequency of the piezoelectric transformer (PZT), such as the operating frequency being selected to be within +/- 20% of the resonance frequency of the piezoelectric transformer (PZT).

13. Consumption meter according to claim 11 or 12, wherein the switch mode driver circuit (DRV) is connected to the power line via a rectifier (RFF), such as via a rectifier and a filter.

14. Consumption meter according to any of claims 9-11, comprising a regulation circuit (RGC) connected to the switch mode driver circuit (DRV), such as a regulation circuit (RGC) connected to the switch mode driver circuit (DRV) in a feed back loop, such as connected via a feedback signal (F1) and a drive signal (D), such as the switch mode driver circuit (DRV) being arranged to adjust the operating frequency in response to a feedback signal (F1).

15. Consumption meter according to any of claims 2-14, wherein a feed back is provided from the secondary electric side to the primary electric side of the piezoelectric transformer (PZT), such as comprising a regulation circuit (RGC) receiving a feedback signal (F2) from the secondary electric side of the piezoelectric transformer (PZT) and generates an according signal to a driver circuit (DRV) connected to the primary electric side of the piezoelectric transformer (PZT).

16. Consumption meter according to any of the preceding claims, wherein the power supply is arranged for connection to an electric power line providing a first voltage (V1) within the range of 50 - 1000 V, such as within the range of 100 - 500 V.

17. Consumption meter according to any of the preceding claims, being one of: an electricity meter, a heat meter, a cooling meter, a water meter, and a gas meter.
